# EUROPEAN PATENT SPECIFICATION

(11) **EP 1 324 109 B1**
(45) Date of publication and mention of the grant of the patent: **01.03.2006**
(21) Application number: 02259009.5
(22) Date of filing: 30.12.2002
(51) Int. Cl.: G02F 1/1343, G02F 1/1335, G02F 1/1362

(54) **Reflective or transflective liquid crystal display and manufacturing method therefor**
Reflektive oder transflektive Flüssigkristallanzeige und Herstellungsverfahren dafür
Afficheur à cristaux liquides réflectif ou transflectif et son procédé de fabrication

(30) Priority: 28.12.2001 JP 2001400996
(43) Date of publication of application: 02.07.2003
(60) Divisional application: 05010368.8
(73) Proprietor: SANYO ELECTRIC CO., LTD., Moriguchi-shi, Osaka (JP)
(72) Inventor: Inoue, Kazuhiro, Motosu-gun, Gifu (JP); Koma, Norio, Motosu-gun, Gifu (JP); Ogawa, Shinji, Ohgaki-Shi, Gifu (JP); Yamashita, Tohru, Anpachi-gun, Gifu (JP); Oda, Nobuhiko, Hashima-Shi, Gifu (JP); Ishida, Satoshi, Ohgaki-Shi, Gifu (JP); Yamada, Tsutomu, Motosu-Gun, Gifu (JP)
(74) Representative: Cross, Rupert Edward Blount

(56) References cited:
- WO-A-00/05601
- US-A- 5 764 324
- US-A- 5 892 563
- US-A- 5 926 240
- PATENT ABSTRACTS OF JAPAN vol. 1996, no. 11, 29 November 1996 (1996-11-29) -& JP 08 184824 A (VICTOR CO OF JAPAN LTD), 16 July 1996 (1996-07-16)
- PATENT ABSTRACTS OF JAPAN vol. 2003, no. 04, 2 April 2003 (2003-04-02) -& JP 2002 365664 A (MATSUSHITA ELECTRIC IND CO LTD), 18 December 2002 (2002-12-18)

## Description

### BACKGROUND OF THE INVENTION

### Field of the Invention

The present invention relates to a reflective or transflective display apparatus or the like having a reflective function.

### Description of Related Art

Liquid crystal display apparatuses (hereinafter referred to as "LCDs") are advantageous in that they are thin and consume relatively little power, and have been widely used for computer monitors and monitors for portable information devices or the like. In LCDs, liquid crystal is sealed between a pair of substrates each having an electrode formed thereon, and the orientation of the liquid crystal disposed between these electrodes is controlled by these electrodes to thereby achieve display. Contrary to CRT (Cathode Ray Tube) displays, electroluminescence (hereinafter referred to as "EL") displays or the like, LCDs require a light source in order to display an image for viewer observation, because LCDs are not, in principle, self-emissive.

Transmissive LCDs, in which a transparent electrode is used as an electrode formed on each substrate and a light source is disposed on the rear or side of the LC panel, can provide bright display even in a dark environment, by controlling the transmission amount of light from the light source through the LC panel. Transmissive LCDs, however, have disadvantages in that power consumption is relatively high due to the light source which must continually illuminate, and that sufficient contrast cannot be ensured when the display is used in a bright environment, such as outdoors under daylight.

In reflective LCDs, on the other hand, external light such as sunlight and room light is used as a light source, and such an ambient light entering the LCD panel is reflected by a reflective electrode formed on the substrate provided on the non-viewing surface side. Thus, light enters through the liquid crystal layer, is reflected by the reflective electrode, and then exits from the LCD panel. By controlling the amount of light radiating from the LCD panel for each pixel, reflective LCDs display an image. While reflective LCDs, which use external light as a light source, differ from LCDs in that their display is dark or black when no such external light is available, they have advantages that power consumption is very low because the power required for the light source can be eliminated and that sufficient contrast can be obtained in the bright environment such as outdoors. Conventional reflective LCDs, however, have been inferior to transmissive LCDs with regard to general display qualities such as color reproductivity and display brightness.

On the other hand, with an increasing demand for reduced power consumption of a device, reflective LCDs, which are more advantageous than transmissive LCDs with respect to power consumption, have been tested for application as highly resolution monitors of portable devices and studied and developed for quality improvement.

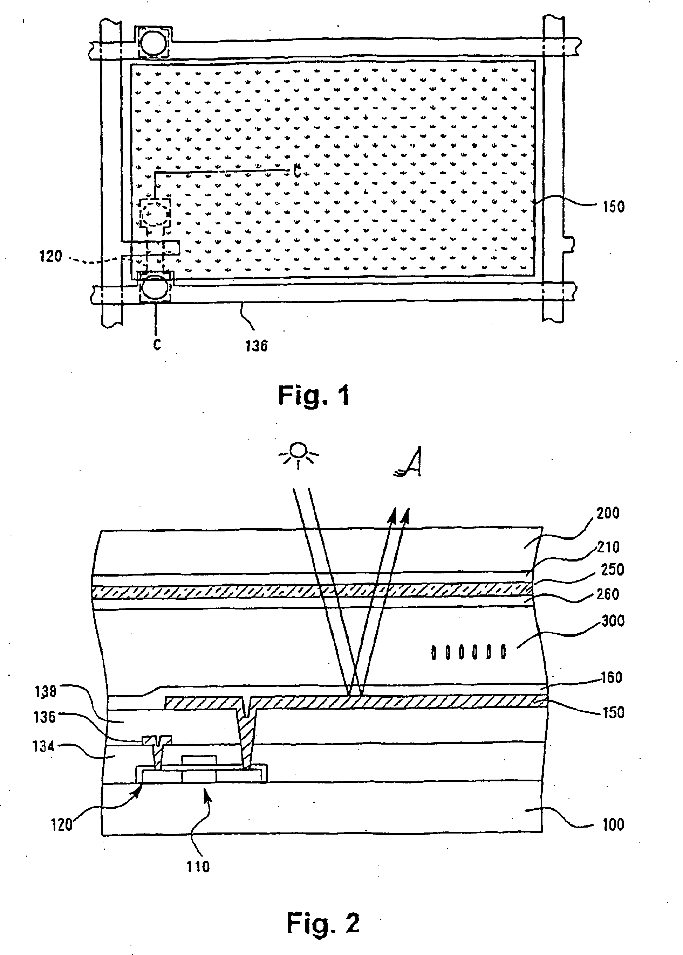

Fig. 1 is a plan view showing one pixel portion of a conventional active matrix reflective LCD in which a thin film transistor (TFT) is provided for each pixel. Fig. 2 schematically shows a cross sectional configuration of the reflective LCD taken along line C-C of Fig. 1.

The reflective LCD comprises a first substrate 100 and a second substrate 200 which are adhered to each other with a predetermined gap therebetween and a liquid crystal layer 300 sealed between the first and second substrates. A glass or plastic substrate is used for the first and second substrate 100 and 200, while a transparent substrate is used as the second substrate 200 located on the viewer side, at least in this example.

On the side facing the liquid crystal layer of the first substrate 100, a thin film transistor (TFT) 110 is formed for each pixel. In this TFT 110, for example, a drain region in an active layer 120 is connected with a data line 136 which supplies a data signal to each pixel via a contact hole formed in an inter-layer insulating film 134. A source region of the TFT 110 is connected with a first electrode (pixel electrode) 150 which is individually formed for each pixel via a contact hole formed to penetrate the inter-layer insulating film 134 and a planarization insulating film 138.

A material having a reflective function, such as Al, Ag, or the like, is employed as the first electrode 150. On the reflective electrode 150, an alignment film 160 is formed so as to control the initial alignment of the liquid crystal layer 300.

When the LCD is a color LCD, on the side facing the liquid crystal layer of the second substrate 200, which is disposed so as to oppose to the first substrate 100, a color filter (R, G, B) 210 is formed, and a transparent electrode 250 comprising a transparent conductive material such as ITO (Indium Tin Oxide) is formed on the color filter 210. Further, on the transparent electrode 250, an alignment film 260 which is similar to the alignment film 160 on the first substrate side is formed.

In the reflective LCD configured as described above, the amount of light which enters the liquid crystal panel, is reflected by the reflective electrode 150, and radiates from the liquid crystal panel, is controlled for each pixel, to thereby produce a desired display.

In LCDs, not limited to the reflective LCD, the liquid crystal is driven by an alternating voltage so as to prevent image persistence. With regard to transmissive LCDs, as both the first electrode on the first substrate and the second electrode on the second substrate should be transparent, ITO is used as a material for both electrodes. Consequently, for AC driving of the liquid crystal, each of the first and second electrodes can apply a positive or negative voltage on substantially the same conditions.

However, in the reflective LCD as shown in Fig. 2, in which a reflective electrode formed by a metal material is used as the first electrode 150 and a transparent electrode formed by a transparent metal oxidation material such as ITO is used as the second electrode 250, certain problems such as display flicker and image persistence in the liquid crystal layer may occur depending on the drive conditions. These problems are noticeable when the liquid crystal is driven at a frequency less than the critical flicker frequency (CFF), for example, which has been reported recently. In order to further reduce power consumption of LCDs, attempts have been made to reduce the frequency for driving the liquid crystal ( the frequency for writing data to liquid crystal (liquid crystal capacitor) at each pixel formed in the region where the first and second electrodes face each other) equal or less than the CFF at which image flicker can be recognized by a human eye, approximately 40Hz - 30Hz, by reducing such a drive frequency to less than 60Hz which is a reference frequency in the NTSC standard, for example. It has been revealed, however, that when each pixel of a conventional reflective liquid crystal panel is driven at less than the CFF, the above-described problems of flicker and image persistence in the liquid crystal layer are significant, which leads to significant deterioration in display quality.

The applicant's research for the causes of such flicker and image persistence in the liquid crystal layer generated in a reflective LCD as shown in Figs. 1 and 2 revealed that asymmetricity of the electrical characteristics of the first and second electrodes relative to the liquid crystal layer 300 is one cause. It is believed that such asymmetricity results from a significant difference between a work function of 4.7eV ~ 5.2eV for the transparent metal oxide such as ITO used in the second electrode 250 and a work function of 4.2eV - 4.3eV for the metal such as Al used in the first electrode 150. Such a difference in the work function would cause there to be a difference of a charge actually induced on the liquid crystal interface via the alignment films 160 and 260, when the same voltage is applied to each electrode. Such a difference of charge induced on the interface between the liquid crystal and the alignment layer at each electrode side would then cause impurity ions or the like to be unevenly located toward only one electrode within the liquid crystal layer, which results in accumulation of remaining DC voltage in the liquid crystal layer 300. As the liquid crystal drive frequency is lowered, the influence of this remaining DC voltage on the liquid crystal increases and generation of flicker and image persistence in the liquid crystal layer becomes more significant. Accordingly, driving the liquid crystal at a frequency not greater than the CFF, in particular, is substantially difficult.

Reflective LCDs in which ITO is used for both the first and second electrodes as in transmissive LCDs and a reflector is separately provided on the outer side of the first electrode (on the side of the first electrode not facing the liquid crystal) are conventionally known. When a reflector is thus provided on the outer side of the fist substrate, however, the length of a light path is increased by an amount corresponding to the thickness of the transparent first electrode 150 and of the transparent first substrate, thereby making the display quality likely to deteriorate due to parallax. Consequently, in reflective LCDs which demand high display quality, a reflective electrode is employed as a pixel electrode, and it is therefore impossible to reduce the drive frequency so as to achieve lower power consumption, because flicker or the like is generated at the lower drive frequency, as described above.

US-A-5,764,324, upon which the preambles of claims 1 and 8 are based, discloses a reflective LCD in which a reflective layer is connected to the switching element and a transparent conductive layer is formed over and electrically connected to the reflective layer.

### SUMMARY OF THE INVENTION

The present invention was conceived in view of the aforementioned problems of the related art and achieves a display apparatus free from effect of flicker and parallax and having a reflective function which provides high display quality and relatively low power consumption, in which electrical properties of the first and second electrodes are equal.

In accordance with one aspect of the present invention, there is provided a display apparatus according to claim 1.

As described above, on the first substrate side, the transparent first electrode having a property similar to that of the second electrode on the second substrate is formed toward the liquid crystal, and the reflective layer is formed on the insulating films such as the inter-layer insulating film and the planarization insulating film and under the first electrode such that the reflective layer is insulated from the switching element of each pixel, so that the liquid crystal layer can be driven by the first and second electrodes with symmetry. In particular, the apparatus of the present invention can achieve high quality display without generating flicker or the like, even when the drive frequency for the liquid crystal layer in each pixel is set lower than, for example, 60Hz.

Preferably also, in a display apparatus as described above, the connection metal layer includes a refractory metal material, at least on a surface contacting the first electrode.

In a preferred embodiment, a difference between a work function of the transparent conductive material of the first electrode and a work function of a transparent conductive material formed on a side of the second substrate toward the liquid crystal layer is 0.5 eV or less.

In accordance with a further aspect of the present invention, there is provided a method of manufacturing a display apparatus according to claim 8.

Thus, in a configuration in which the first electrode is disposed toward the liquid crystal, by interposing the connection metal layer between the first electrode and the thin film transistor, it is possible to prevent deterioration of the electrodes and active layer of the thin film transistor when patterning the reflective layer under the first electrode. Consequently, the first electrode formed on the reflective layer can be reliably connected with the thin film transistor.

### BRIEF DESCRIPTION OF THE DRAWINGS

These and other advantages of the invention will be explained in the description below, in connection with the accompanying drawings, in which:
Fig. 1 is a view showing a plan configuration of a section of a conventional active matrix reflective LCD on the first substrate side;
Fig. 2 is a view schematically showing a cross sectional configuration of the conventional reflective LCD taken along line C-C of Fig. 1;
Fig. 3A is a view schematically showing a plan configuration of an active matrix reflective LCD according to an embodiment of the present invention on the first substrate side;
Fig. 3B is a view schematically showing a cross sectional configuration of the reflective LCD taken along line A-A of Fig. 3A;
Fig. 4A is a view schematically showing another cross sectional configuration of the reflective LCD taken along line A-A of Fig. 3A;
Fig. 4B is a view schematically showing another cross sectional configuration of the reflective LCD taken along line A-A of Fig. 3A;
Fig. 5A is a view schematically showing a plan configuration of an active matrix transflective LCD according to the embodiment of the present invention on the first substrate side;
Fig. 5B is a view schematically showing a cross sectional configuration of the transflective LCD taken along line B-B of Fig. 5A; and

### DETAILED DESCRIPTION OF THE PREFERRED EMBODIMENT

A preferred embodiment of the present invention, hereinafter referred to simply as the embodiment, will be described with reference to the drawings.

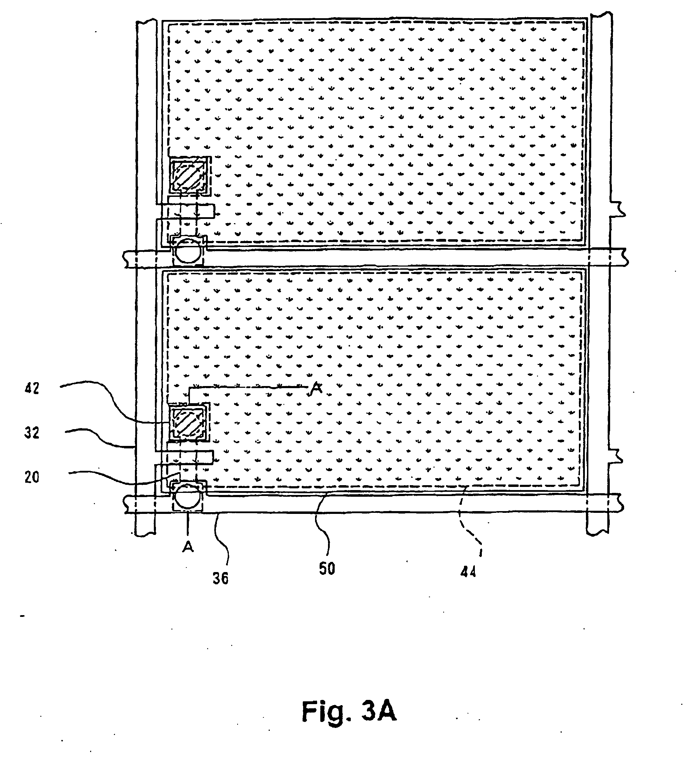

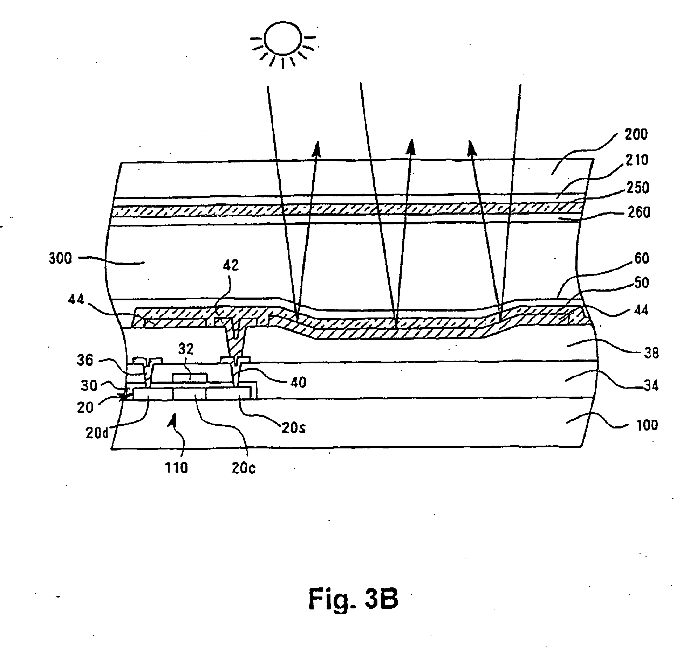

Fig. 3A is a plan view showing a partial configuration on the first substrate side of a reflective active matrix LCD which is an example reflective LCD according to the embodiment of the present invention. Fig. 3B is a schematic sectional view of the LCD taken along line A-A of Fig. 3A. In an active matrix LCD, a plurality of pixels are provided in a matrix within the display region and a switching element such as a TFT is provided for each pixel. The switching element is formed for each pixel on one of first and second substrate side, such as on the side of the first substrate 100, and is connected with a pixel electrode (first electrode) 50 which is formed in individually pattern.

A transparent substrate such as glass is used for the first and second substrate 100 and 200. When the LCD is a color LCD, a color filter 210 is formed on the side of the second substrate 200 facing the first substrate 100, as in the conventional LCD. On the color filter 210, a second electrode 250 made of a transparent conductive material such as IZO (Indium Zinc Oxide) or ITO is formed. In an active matrix LCD, the second electrode 250 is formed as a common electrode for all pixels. Further, on the second electrode 250, an alignment film 260 made of polyimide or the like is formed.

According to the present embodiment, the apparatus on the second substrate side configured as described above employs an electrode structure whose electrical property is similar to that of an electrode on the first substrate with regard to the liquid crystal layer 300. More specifically, as shown in Fig. 3B, the first electrode 50 which is made of a material having a work function similar to that of the second electrode 250, that is, a transparent conductive material as used in the second electrode 250 such as IZO and ITO, and not a reflective metal electrode as conventionally employed, is formed immediately under an alignment film 60 on the first substrate 100. Then, in order to create a reflective LCD, a reflective layer 44 which reflects incident light entering through the second substrate 200 is formed under the first electrode 50.

By forming the first electrode 50 of the same material as used for the second electrode 250, electrodes having the same work function sandwich the liquid crystal layer 300, via the alignment layers 60 and 260, respectively, so that the liquid crystal layer 300 can be AC driven by the first and second electrodes 50 and 250 with very good symmetry. Here, the work functions of the first and second electrodes 50 and 250 need not be completely identical and may be as approximate to each other as possible so that the liquid crystal layer 300 can be symmetrically driven. When the difference between the work functions of the both electrodes is approximately 0.5eV or less, high quality display without flicker or image persistence in the liquid crystal layer can be achieved, even when the drive frequency for the liquid crystal is set to CFF or lower, as described above.

In order to satisfy the above conditions for the electrodes, for example, IZO (whose work function is 4.7eV ~ 5.2eV) can be used for the first electrode 50 and ITO (whose work function is 4.7eV - 5.0eV) can be used for the second electrode 250, or vice versa. The material used for each electrode may be selected in consideration of process properties such as transmissivity and patterning precision and manufacturing cost.

With regard to the reflective layer 44, a material with good reflective property, such as Al, Ag, and alloys thereof (Al-Nd alloy is used in the present embodiment), is used at least on the top surface side (on the surface side toward the liquid crystal layer). While the reflective layer 44 may be a single layer made of a metal material such as Al, a layer made of a refractory metal (high melting point metal) such as Mo may be additionally provided as a lower buffer layer which contacts a planarization insulating film 38. With such a lower buffer layer, the adhesiveness between the reflective layer 44 and the planarization insulating film 38 can be enhanced to thereby improve the reliability of the device. In the configuration shown in Fig. 3B, the planarization insulating film 38 includes, within each pixel region, a slant surface formed at a desired angle, and the reflective layer 44 which is formed so as to cover the planarization insulating film 38 also has a similar slant portion on the surface. By forming such a slant surface at an optical angle and location, it is possible to collect and radiate outside light for each pixel, and therefore the display brightness at the front position of the display can be increased, for example. It should be understood, however, that such a slant surface need not necessarily be provided.

The reflective layer 44, which is made of a conductive material such as Al, as described above, is electrically insulated from the first electrode 50 formed on the reflective layer 44 because the first electrode 50 is formed by sputtering IZO or ITO, when these materials are used. More specifically, because the reflective layer 44 made of Al, when exposed to the sputtering atmosphere, undergoes oxidation reaction on its surface and is covered with a natural oxide film. Therefore, according to the present embodiment, rather than using this reflective layer 44 as a first electrode which drives the liquid crystal as in the convention reflective LCD, the transparent conductive layer formed on the reflective film 44 is used as the first electrode 50 for applying a voltage in accordance with the display data to the liquid crystal 300.

In recent years, so-called transflective LCDs having both light transmission function and reflective function have been proposed. For such a transflective LCD, a configuration is known in which a pixel electrode such as ITO is first formed and a reflective electrode such as Al is then formed to cover a portion of the transparent electrode, as in the transmissive LCD. In a transflective LCD configured such that the transparent electrode layer and the reflective electrode layer are sequentially disposed in this order from the substrate side, these two electrode layers are electrically connected and function as a single pixel electrode. However, because, in this single pixel electrode, the reflective electrode is located toward the liquid crystal layer, due to the difference of work functions between this reflective electrode and the second electrode, the liquid crystal layer 300 cannot be symmetrically driven. While disposing the electrode layers in the reverse order in order to form a single pixel electrode so as to improve the symmetry in electrical properties may be considered, this approach does not solve the above problem. Specifically, as described above, a natural oxide film is likely to be formed on the surface of a metal material such as Al and Ag used for the reflective electrode. In particular, when such a metal layer which is formed undergoes sputtering for forming the transparent conductive material layer thereon, the metal layer is covered with a natural oxide film and is insulated from the transparent electrode. Consequently, even if the order of the electrodes is reversed, the liquid crystal cannot be driven by the transparent electrode on the first substrate side, and it is impossible to match the electrically properties of the first and second substrate sides with regard to the liquid crystal.

According to the present embodiment, on the other hand, while the reflective layer 44 is insulated from both the first electrode 50 and the TFT 110, the first electrode 50 and the TFT 110 can be reliably connected because a connection metal layer 42 is interposed between the first electrode 50 and the TFT 110 (for example, a source electrode 40 of the TFT 110). Further, on the first substrate, the liquid crystal can be driven by the first electrode 50 made of a transparent conductive material and disposed adjacent to the liquid crystal layer, as in the second substrate.

Here, the following conditions, for example, are required for the above-mentioned metal layer 42 employed in the present embodiment for connecting the first electrode 50 and the TFT 110:
(i) the metal layer 42 should be electrically connected with the first electrode 50 made of IZO, ITO, or the like;
(ii) the metal layer 42 should be electrically connected with the source electrode 40 when the source electrode 40 made of Al, for example, is provided in the TFT 110 as shown in Fig. 3B and should be electrically connected with a semiconductor (poly-silicon) active layer when the source electrode 40 is omitted; and
(iii) the metal layer 42 should not be removed by an etchant used for patterning the reflective layer individually for each pixel.

It is preferable that a refractory metal material such as Mo, Ti, and Cr is used for the metal layer 42.

A configuration for accomplishing reliable connection between the first electrode 50 and the corresponding TFT 110 as provided by the present embodiment and a manufacturing method of achieving this configuration will be described.

A top gate type TFT is employed as the TFT 110 and polycrystalline silicon (p-Si) obtained by poly-crystallization of amorphous silicon (a-Si) by laser annealing is used for the active layer 20. Of course, the TFT 110 is not limited to a top gate type p-Si and may be a bottom gate type, and a-Si may be used for the active layer. While either n or p conductivity type impurities may be doped in the source and drain regions 20s and 20d of the active layer 20 in the TFT 110, in the present embodiment, an n conductivity type impurity such as phosphorus is doped to form a n-ch TFT 110.

The active layer 20 of the TFT 110 is covered with a gate insulating film 30, and a gate electrode 32 which is made of Cr or the like and also functions as a gate line is formed on the gate insulating film 30. After formation of the gate electrode 32, the above-mentioned impurities are doped in the active layer 20 using the gate electrode 32 as a mask to form the source and drain regions 20s and 20d and also form a channel region 20c in which no impurities are doped. Then, an inter-layer insulating film 34 is formed so as to cover the whole TFT 110. After contact holes are formed in the inter-layer insulating film 34, electrode materials are formed, so that the source electrode 40 and the drain electrode 36 are connected with the source and drain regions 20s and 20d of the p-Si active layer 20, respectively. In the present embodiment, the drain electrode 36 also functions as a data line for supplying a data signal in accordance with the display data to each TFT 110. The source electrode 40, on the other hand, is connected with the first electrode 50 which is a pixel electrode, as will be described below.

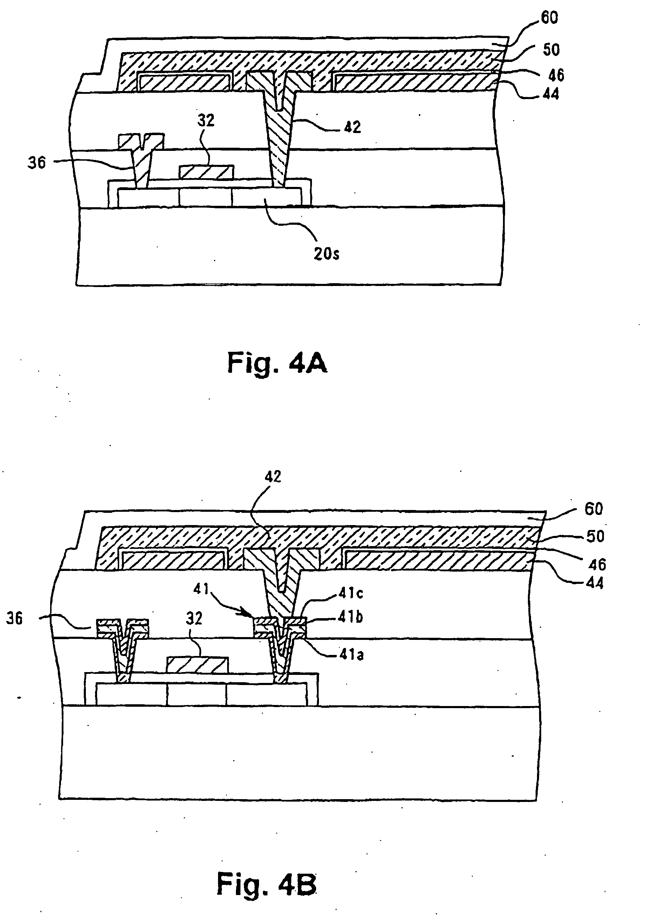

After formation of the source electrode 40 and the drain electrode 36, the planarization insulation film 38 made of a resin material such as acrylic resin is formed so as to cover the whole surface of the substrate. A contact hole is then formed in a portion of the planarization insulating film 38 corresponding to the source electrode 40, and the connection metal layer 42 is formed in this contact hole so that the source electrode 40 and the metal layer 42 are connected. By employing a metal material such as Mo for the metal layer 42 when Al or the like is used for the source electrode 40, a good ohmic contact can be achieved between the metal layer 42 and the source electrode 40. It should be noted that the source electrode 40 can be eliminated as shown in Fig. 4A. In such a case, although the metal layer 42 contacts the silicon active layer 20 of the TFT 110, a metal such as Mo can also establish an ohmic contact with such a semiconductor material.

After disposing and patterning the connection metal layer 42, a material with superior reflective property such as an Al-Nd alloy and Al for forming the reflective layer 44, is disposed on the whole surface of the substrate by evaporation or sputtering. The reflective material thus disposed is removed by etching so that none remains around the source region of the TFT (where the metal layer 42 is formed) in such a manner that the reflective material does not disturb contact between the metal layer 42 and the first electrode 50 subsequently formed. Thus, the reflective layer 44 which is pattered as shown in Fig. 3A is formed in each pixel. According to the present embodiment, in order to prevent the TFT 110 (particularly the channel region 20c thereof) from being irradiated with light to generate a leak current and in order to increase the region in which reflection can be achieved (namely, the display region) to the fullest extent possible, the reflective layer 44 is actively formed over the channel region of the TFT 110, as shown in Fig. 3B.

With regard to the patterning of the reflective layer 44 as described above, the metal layer 42 made of Mo or the like has a sufficient thickness (0.2 µm, for example) and sufficient resistance to an etchant. Accordingly, even after the reflective layer 44 on the metal layer 42 is etched for removal, the metal layer 42 is not removed and can completely remain within the contact hole. Further, in the absence of the metal layer 42, the source electrode 40, which is often formed by the same material (such as Al) as used for the reflective layer 44, would undergo corrosion by the etchant used for the reflective layer 44, thereby causing disconnection or the like. Therefore, according to the present embodiment, the metal layer 42 is provided so as to resist the patterning of the reflective layer 44, so that preferable electrical connection can be maintained between the reflective layer 44 and the source electrode 40.

After the reflective layer 44 is patterned, a transparent conductive layer is disposed by sputtering so as to cover the whole substrate including the reflective layer 44. At this time, while the surface of the reflective layer 44 made of A1 or the like is covered with an insulative natural oxide film (see numeral 46 in Fig. 4A) as described above, a refractory metal such as Mo does not undergo surface oxidation even when exposed to the sputtering atmosphere. Therefore, the metal layer 42 exposed in the contact region can make ohmic contact with the transparent conductive layer for the first electrode which is disposed on the metal layer 42. After formation, the transparent conductive layer is further patterned in an individual form for each pixel as shown in Fig. 3A, thereby forming the pixel electrode 50 (the first electrode). Further, after the first electrode 50 is formed in each pixel region, the alignment film 60 made of polyimide or the like is formed so as to cover the whole substrate to complete the device on the first substrate side. Then, the second substrate 200 on which various layers are formed up to the alignment film 260 and the first substrate 100 are adhered to each other at the peripheral portions of the substrates with a predetermined gap therebetween, and liquid crystal is sealed between these substrates to complete a liquid crystal display apparatus.

As shown in Fig. 4B, the metal layer 42 of the present embodiment can also maintain preferable connection with the source electrode 41 when the source electrode 41 has a multi-layered configuration in which an Al layer is interposed between refractory metal layers such as Mo. More specifically, the source electrode 41 (also the drain electrode 37 which also functions as the data line) shown in Fig. 4B is formed by sequentially disposing a Mo layer 41a, an Al layer 41b, and a Mo layer 41c in this order from the active layer side. Because the Mo layer 41a is formed toward the active layer 20 made of p-Si, it is possible to prevent Si atoms from moving into the Al layer 41b, causing a defect in the active layer. Further, because the Mo layer 41c is formed as the top layer, it is possible to maintain preferable electrical connection between the metal layer 42 and the source electrode even through contact formation and formation and etching of the metal layer 42. According to the present embodiment, because the metal layer 42 is made of Mo or the like which is also used for the top layer of the source electrode 41, good contact is also established between the metal layer 42 and the source electrode 41 shown in Fig. 4B.

Further, the metal layer 42 of the present embodiment may have a multi-layered configuration as in the source electrode 41 shown in Fig. 4B. The multi-layered configuration may be, for example, a three-layered configuration including, from the bottom, a refractory metal layer such as Mo, a conductive layer such as Al, and a refractory metal layer such as Mo, or a two-layered configuration including, from the bottom, a conductive layer such as Al and a refractory metal layer such as Mo. When such a multi-layered metal layer 42 is employed, the source electrode 40 disposed under the metal layer 42 may have the above-mentioned multi-layered configuration as shown in Fig. 4B or a single-layer configuration such as Al. Further, when the metal layer 42 is in direct contact with the active layer 20 as shown in Fig. 4A, the metal layer 42 may employ the three-layer or two-layered configuration as described above. In order to maintain electrical connectivity after formation of an insulating film on the surface when the first electrode 50 is formed, it is necessary that the metal layer 42 is able to resist etching and remain stable. It is preferable that a refractory metal layer is formed at least on the surface of the metal layer 42 which contacts the first electrode 50.

Transflective LCDs will next be described. In the above example, a reflective LCD in which the reflective layer 44 is formed on substantially the whole region within one pixel region has been described. The present invention is, however, also applicable to a transflective LCD in addition to such a reflective LCD.

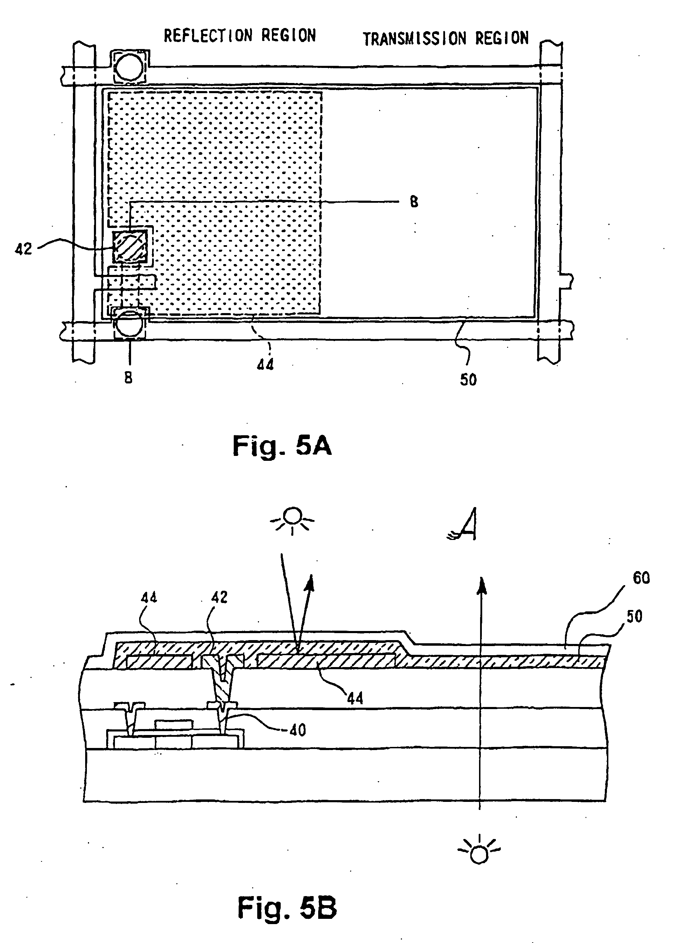

Fig. 5A shows a plan configuration of a transflective active matrix LCD corresponding to one pixel, and Fig. 5B is a cross sectional view schematically showing the LCD taken along line B-B of Fig. 5A. In the reflective LCD shown in Figs. 3A and 3B, the reflective layer 44 is formed in substantially the region of one pixel (except the TFT region and the contact region). In the transflective LCD as shown in Figs. 5A and 5B, on the other hand, a reflective region in which a reflective layer 44 and a transparent first electrode 50 are disposed in a laminate form and a light transmissive region in which the reflective layer 44 is eliminated and only the transparent first electrode 50 is disposed are formed within one pixel.

In such a transflective LCD, the first electrode 50 is similarly disposed closer to the liquid crystal layer than the reflective layer 44 and the reflective layer 44 is insulated from the first electrode 50 formed immediately above the reflective layer 44 by the natural oxide film 46. Further, the reflective layer 44 is removed from the contact region between the TFT 110 region and the first electrode 50 so as not to interrupt contact therebetween. Accordingly, it is similarly possible for the liquid crystal layer 300 to be symmetrically driven by the first electrode 50 and the second electrode 250 having similar work functions via the respective alignment films. It is further possible to switch the light source in accordance with the intensity of ambient light or the like to achieve either reflection or transmission display.

As described above, according to the embodiment of the present invention, even when a reflective layer must be formed on one of substrate of a display, as in a reflective or transflective LCD, first and second electrodes having similar properties can be disposed symmetrically with regard to the liquid crystal layer, and the liquid crystal can therefore be symmetrically driven using an AC current. As a result, high quality display can be achieved without generation of flicker or image persistence, even when the drive frequency for the liquid crystal is not greater than the CFF, for example.

While the preferred embodiment of the present invention has been described using specific terms, such description is for illustrative purposes only, and it is to be understood that changes and variations may be made without departing from the scope of the appended claims.

## Claims

1. A display apparatus comprising a first substrate (100) having a first electrode (50), a second substrate (200) having a second electrode (250), and a liquid crystal layer (300) sealed between the first substrate and the second substrate for performing display, wherein
the first substrate (100) further includes:
a switching element (110) provided for each pixel;
a reflective layer (44) which is formed on an insulating film (38) covering the switching element (110), the reflective layer reflecting light entering the liquid crystal layer through the second substrate (200);
the first electrode (50) being formed by a transparent conductive material covering the reflective layer (44) and being electrically connected with the switching element, and a connection metal layer (42) formed within a contact hole formed in the insulating film (38) covering the switching element (110), **characterized in that** the reflective layer (44) is insulated from both the switching element (110) and the first electrode (50), and the switching element (110) and the first electrode (50) are electrically connected via the connection metal layer (42).

2. A display apparatus according to claim 1, wherein
the connection metal layer (42) includes a refractory metal material at least on a surface contacting the first electrode.

3. A display apparatus according to either one of claims 1 and 2, wherein
a difference between a work function of the transparent conductive material of the first electrode (50) and a work function of a transparent conductive material formed on a side of the second substrate (200) toward the liquid crystal layer (300) is 0.5 eV or less.

4. A display apparatus according to claim 3, wherein each of the transparent conductive material of the first electrode and the transparent conductive material of the second electrode is Indium Tin Oxide or Indium Zinc Oxide.

5. A display apparatus according to any preceding claim, wherein the first electrode is insulated from the reflective layer by a natural oxide film on the reflective layer.

6. A display apparatus according to any preceding claim, wherein there is formed within each pixel a reflective region in which the reflective layer (44) and the transparent first electrode (50) are disposed in the laminate form and a light transmissive region in which the reflective layer (44) is eliminated and only the transparent first electrode (50) is disposed.

7. A display apparatus according to claim 3, further comprising means for providing a drive frequency for the liquid crystal layer in each pixel which is less than 60 Hz.

8. A method of manufacturing a display apparatus including a first substrate having a first electrode, a second substrate having a second electrode, and a liquid crystal layer sealed between the first substrate and the second substrate, the method comprising the steps of:
forming a thin film transistor on the first substrate;
forming an insulating film formed from at least one layer so as to cover the thin film transistor:
forming a contact hole in a region of the insulating film corresponding to an active layer of the thin film transistor;
forming a connection metal layer in the region of the contact hole;
forming a reflective material layer so as to cover the insulating film and the connection metal layer, and
forming the first electrode from a transparent conductive material so as to cover the reflective layer, **characterized by** patterning the reflective material layer so that the reflective material layer remains in a predetermined pixel region other than a region above the connection metal layer so as to be insulated from the thin film transistor, forming the first electrode so as to be insulated from the reflective layer and to cover the connection metal layer and electrically connecting the first electrode to the thin film transistor via the connection metal layer.

## Revendications

1. Appareil d'affichage comprenant un premier substrat (100) ayant une première électrode (50), un deuxième substrat (200) ayant une deuxième électrode (250), et une couche de cristaux liquides (300) scellée entre le premier substrat et le deuxième substrat pour réaliser l'affichage, dans lequel
le premier substrat (100) comprend en outre :
un élément de commutation (110) prévu pour chaque pixel ;
une couche réflective (44) qui est formée sur un film isolant (38) couvrant l'élément de commutation (110), la couche réflective réfléchissant la lumière entrant dans la couche de cristaux liquides à travers le deuxième substrat (200) ;
la première électrode (50) étant formée par un matériau conducteur transparent couvrant la couche réflective (44) et étant connectée électriquement à l'élément de commutation, et une couche métallique de connexion (42) formée dans un trou de contact formé dans le film isolant (38) couvrant l'élément de commutation (110),
**caractérisé en ce que** la couche réflective (44) est isolée de l'élément de commutation (110) et de la première électrode (50), et l'élément de commutation (110) et la première électrode (50) sont connectés électriquement via la couche métallique de connexion (42).

2. Appareil d'affichage selon la revendication 1, dans lequel
la couche métallique de connexion (42) comprend un matériau métallique réfractaire au moins sur une surface en contact avec la première électrode.

3. Appareil d'affichage selon la revendication 1 ou la revendication 2, dans lequel
une différence entre un travail d'extraction du matériau conducteur transparent de la première électrode (50) et un travail d'extraction d'un matériau conducteur transparent formé sur un côté du deuxième substrat (200) vers la couche de cristaux liquides (300) est de 0,5 eV ou moins.

4. Appareil d'affichage selon la revendication 3, dans lequel chaque matériau parmi le matériau conducteur transparent de la première électrode et le matériau conducteur transparent de la deuxième électrode est de l'oxyde d'indium et d'étain ou de l'oxyde d'indium et de zinc.

5. Appareil d'affichage selon l'une quelconque des revendications précédentes, dans lequel la première électrode est isolée de la couche réflective par un film d'oxyde naturel sur la couche réflective.

6. Appareil d'affichage selon l'une quelconque des revendications précédentes, dans lequel sont formées, dans chaque pixel, une région réflective dans laquelle la couche réflective (44) et la première électrode transparente (50) sont disposées sous la forme laminée et une région transmissive de lumière dans laquelle la couche réflective (44) est éliminée et seule la première électrode transparente (50) est disposée.

7. Appareil d'affichage selon la revendication 3, comprenant en outre un moyen destiné à fournir une fréquence d'entraînement pour la couche de cristaux liquides dans chaque pixel qui est inférieure à 60 Hz.

8. Procédé de fabrication d'un appareil d'affichage comprenant un premier substrat ayant une première électrode, un deuxième substrat ayant une deuxième électrode, et une couche de cristaux liquides scellée entre le premier substrat et le deuxième substrat, le procédé comprenant les étapes consistant à :
former un transistor à film mince sur le premier substrat ;
former un film isolant formé à partir d'au moins une couche de manière à couvrir le transistor à film mince ;
former un trou de contact dans une région du film isolant correspondant à une couche active du transistor à film mince ;
former une couche métallique de connexion dans la région du trou de contact ;
former une couche de matériau réflectif de manière à couvrir le film isolant et la couche métallique de connexion, et
former la première électrode à partir d'un matériau conducteur transparent de manière à couvrir la couche réflective, **caractérisé par** le modelage de la couche de matériau réflectif de sorte que la couche de matériau réflectif reste dans une région de pixel prédéterminée autre qu'une région située au-dessus de la couche métallique de connexion de manière à être isolée du transistor à film mince, la formation de la première électrode de manière à être isolée de la couche réflective et à couvrir la couche métallique de connexion et la connexion électrique de la première électrode au transistor à film mince via la couche métallique de connexion.

## Patentansprüche

1. Anzeigevorrichtung, die ein erstes Substrat (100) mit einer ersten Elektrode (50), ein zweites Substrat (200) mit einer zweiten Elektrode (250), und eine Flüssigkristallschicht (300) umfasst, die zwischen dem ersten Substrat und dem zweiten Substrat zur Bewerkstelligung einer Anzeige gekapselt ist, wobei
das erste Substrat (100) ferner enthält:
ein Schaltelement (110), das für jedes Pixel vorgesehen ist;
eine reflektierende Schicht (44), die auf einem Isolationsfilm (38), der das Schaltelement (110) bedeckt, ausgebildet ist, wobei die reflektierende Schicht das in die Flüssigkristallschicht durch das zweite Substrat (200) eintretende Licht reflektiert; wobei
die erste Elektrode (50) gebildet wird von einem transparenten leitenden Material, das die reflektierende Schicht (44) abdeckt und mit dem Schaltelement elektrisch verbunden ist, und einer Verbindungsmetallschicht (42), die innerhalb eines Kontaktloches ausgebildet ist, das in dem das Schaltelement (110) abdeckenden Isolationsfilm (38) ausgebildet ist, **dadurch gekennzeichnet, dass** die reflektierende Schicht (44) sowohl vom Schaltelement (110) als auch von der ersten Elektrode (50) isoliert ist und das Schaltelement (110) und die erste Elektrode (50) über die Verbindungsmetallschicht (42) elektrisch verbunden sind.

2. Anzeigevorrichtung nach Anspruch 1, wobei die Verbindungsmetallschicht 42 wenigstens auf einer Oberfläche, die die erste Elektrode kontaktiert, ein refraktorisches Metallmaterial enthält.

3. Anzeigevorrichtung nach Anspruch 1 oder 2, wobei
eine Differenz zwischen einer Arbeitsfunktion des transparenten leitenden Materials der ersten Elektrode (50) und einer Arbeitsfunktion eines transparenten leitenden Materials, das auf einer Seite des zweiten Substrats (200) in Richtung zur Flüssigkristallschicht (300) ausgebildet ist, gleich 0,5 eV oder weniger ist.

4. Anzeigevorrichtung nach Anspruch 3, wobei jeweils das transparente leitende Material der ersten Elektrode und das transparente leitendende Material der zweiten Elektrode Indium-Zinn-Oxid oder Indium-Zink-Oxid ist.

5. Anzeigevorrichtung nach irgendeinem der vorangehenden Ansprüche, wobei die erste Elektrode von der reflektierenden Schicht mittels eines natürlichen Oxidfilms auf der reflektierenden Schicht isoliert ist.

6. Anzeigevorrichtung nach irgendeinem der vorangehenden Ansprüche, wobei innerhalb jedes Pixels ein reflektierender Bereich ausgebildet ist, in welchem die reflektierende Schicht (44) und die transparente erste Elektrode (50) in Laminatform angeordnet sind, sowie ein lichtdurchlässiger Bereich, in welchem die reflektierende Schicht (44) eliminiert ist und nur die transparente erste Elektrode (50) angeordnet ist.

7. Anzeigevorrichtung nach Anspruch 3, die ferner ein Mittel zum Bereitstellen einer Ansteuerungsfrequenz für die Flüssigkristallschicht in jedem Pixel, die kleiner als 60 Hz ist, umfasst.

8. Verfahren zur Herstellung einer Anzeigevorrichtung, die ein erstes Substrat mit einer ersten Elektrode, ein zweites Substrat mit einer zweiten Elektrode und eine Flüssigkristallschicht, die zwischen dem ersten Substrat und dem zweiten Substrat gekapselt ist, enthält, wobei das Verfahren die Schritte umfasst:
Ausbilden eines ersten Dünnschichttransistors auf dem ersten Substrat;
Ausbilden eines Isolationsfilms, der aus wenigstens einer Schicht gebildet wird, um somit den Dünnschichttransistor abzudecken;
Ausbilden eines Kontaktloches in einem Bereich des Isolationsfilms, der einer aktiven Schicht des Dünnschichttransistors entspricht;
Ausbilden einer Verbindungsmetallschicht im Bereich des Kontaktes;
Ausbilden einer reflektierenden Materialschicht, um somit den Isolationsfilm und die Verbindungsmetallschicht abzudecken; und
Ausbilden der ersten Elektrode aus einem transparenten leitenden Material, um somit die reflektierende Schicht abzudecken, **gekennzeichnet durch** das Mustern der reflektierenden Materialschicht, so dass die reflektierende Materialschicht in einem vorgegebenen Pixelbereich mit Ausnahme eines Bereiches oberhalb der Verbindungsmetallschicht zurückbleibt, um somit vom Dünnschichttransistor isoliert zu sein, wobei die erste Elektrode so ausgebildet wird, dass sie von der reflektierenden Schicht isoliert ist und die Verbindungsmetallschicht abdeckt und die erste Elektrode mit dem Dünnschichttransistor über die Verbindungsmetallschicht elektrisch verbindet.
